# EUROPEAN PATENT APPLICATION

(11) **EP 1 947 708 A1**
(43) Date of publication of application: **23.07.2008**
(21) Application number: 06822912.9
(22) Date of filing: 02.11.2006
(51) Int. Cl.: H01L 51/50, C09K 11/06

(54) **ORGANIC ELECTROLUMINESCENT ELEMENT**

(30) Priority: 07.11.2005 JP 2005321885
(71) Applicant: Idemitsu Kosan Co., Ltd., Chiyoda-ku Tokyo 100-8321 (JP)
(72) Inventor: ARAKANE, Takashi, Sodegaura-shi, Chiba 299-0293 (JP); KUMA, Hitoshi, Sodegaura-shi, Chiba 299-0293 (JP); FUKUOKA, Kenichi, Sodegaura-shi, Chiba 299-0293 (JP); YAMAMOTO, Hiroshi, Sodegaura-shi, Chiba 299-0293 (JP); HOSOKAWA, Chishio, Sodegaura-shi, Chiba 299-0293 (JP)
(74) Representative: Gille Hrabal Struck Neidlein Prop Roos
(86) International application number: PCT/JP2006/321994
(87) International publication number: WO 2007/052759

(57) **Abstract**

An organic electroluminescent device 1 comprising, an emitting layer (50) and an electron-transporting layer (60) between a cathode (80) and an anode (20), the electron-transporting layer (60) comprising a compound represented by formula (1), the emitting layer (50) comprising a host material which is a compound with an energy gap of 2.8 eV or less represented by formula (2) and a dopant which is an indenoperylene derivative,

A-B (1)

wherein A is an aromatic hydrocarbon group with three or more carbocycles and B is a substituted or unsubstituted heterocyclic group,

X-(Y)ₙ (2)

wherein X is a condensed aromatic ring group with three or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.

## Description

### Technical Field

The invention relates to an organic electroluminescent device. In detail, it relates to an organic electroluminescent device having a long life time and a high luminous efficiency, and emitting red light.

### Technical Background

An organic EL device is a self-emission device by the use of the principle that a fluorescent compound emits light by the recombination energy of holes injected from an anode and electrons injected from a cathode when an electric field is impressed.

Since C. W. Tang et al. of Eastman Kodak Co. reported a low-voltage driven organic EL device in the form of a stacked type device (C. W. Tang, S. A. Vanslyke, Applied Physics Letters, Vol. 51, p.913, 1987, and the like) (Non-patent Document 1), studies on organic EL devices wherein organic materials are used as the constituent materials has actively conducted.

Tang et al. uses tris(8-quinolinol) aluminum for an emitting layer and a triphenyldiamine derivative for a hole-transporting layer in the stacked structure. The advantages of the stacked structure are to increase injection efficiency of holes to the emitting layer, to increase generation efficiency of excitons generated by recombination by blocking electrons injected in the cathode, to confine the excitons generated in the emitting layer, and so on. Like this example, as the structure of the organic EL device, a two-layered type of a hole-transporting (injecting) layer and an electron-transporting emitting layer, and a three-layered type of a hole-transporting (injecting) layer, an emitting layer and an electron-transporting (injecting) layer are widely known. In such stacked structure devices, the device structures and the fabrication methods have been contrived to increase recombination efficiency of injected holes and electrons.

As luminescence materials used in an organic EL device, there are known luminescence materials such as chelate complexes including tris(8-quinolinol)aluminum complexes, coumarin complexes, tetraphenylbutadiene derivatives, bis-styrylarylene derivatives and oxadiazole derivatives. It has been reported that these materials emit light in a visible region from red to blue. Therefore the realization of color display devices is expected (for example, Patent Documents 1 to 3). However, its luminous efficiency and lifetime did not attain a practical level and were insufficient. The full-color display requires three primary colors (blue, green and red), especially a red device with a high efficiency.

Recently, for example, Patent Document 4 discloses a red luminescent device in which a naphthacene or pentacene derivative is added in an emitting layer. This luminescent device is excellent in red purity, but its applied voltage is as high as 11 V and the half life of luminance is as insufficient as about 150 hours. Patent Document 5 discloses a device in which a dicyanomethylene (DCM) type compound is added in an emitting layer but the red purity thereof is insufficient. Patent Document 6 discloses a red luminescent device in which an amine type aromatic compound is added in an emitting layer. The device has excellent CIE chromaticity (0.64, 0.33) and color purity but the driving voltage is high. Patent Documents 7 and 8 disclose a device in which an amine type aromatic compound and Alq are used in an emitting layer. The device emits light in red, but the efficiency is low and the lifetime is short.

Patent Documents 9 discloses a device in which an amine type aromatic compound and DPVDPAN are used in an emitting layer. The emission color of a device with a high efficiency is orange and the efficiency of a device emitting light in red is low.

Patent document 10 discloses a device wherein a dicyanoanthracene derivative and an indenoperylene derivative are used in an emitting layer, and a metal complex is used in an electron-transporting layer. However, the emission color thereof is reddish orange.

Patent document 11 discloses a device wherein a naphthacene derivative and an indenoperylene derivative are used in an emitting layer, and a naphthacene derivative is used in an electron-transporting layer. However, the device does not have a practical efficiency.

[Patent document 1] JP-A-8-239655
[Patent document 2] JP-A-7-138561
[Patent document 3] JP-A-3-200289
[Patent document 4] JP-A-8-311442
[Patent document 5] JP-A-3-162481
[Patent document 6] JP-A-2001-81451
[Patent document 7] WO01/23497
[Patent document 8] JP-A-2003-40845
[Patent document 9] JP-A-2003-81924
[Patent document 10] JP-A-2001-307885
[Patent document 11] JP-A-2003-338377
[Non-patent document 1] C.W. Tang, S.A. Vanslyke, Applied Physics Letters, 51, 913, 1987

An object of the invention is to provide an organic EL device having practical efficiency and lifetime without complicated structure.

### Disclosure of the Invention

The invention provides the following organic EL device.
1. An organic electroluminescent device comprising,
   an emitting layer and an electron-transporting layer between a cathode and an anode,
   the electron-transporting layer comprising a compound represented by formula (1),
   the emitting layer comprising a host material which is a compound with an energy gap of 2.8 eV or less represented by formula (2) and a dopant which is an indenoperylene derivative,

   A-B (1)

   wherein A is an aromatic hydrocarbon group with three or more carbocycles and B is a substituted or unsubstituted heterocyclic group,

   X-(Y)ₙ (2)

   wherein X is a condensed aromatic ring group with three or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.
2. The organic electroluminescent device according to 1, wherein the compound represented by formula (1) contained in the electron-transporting layer is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.
3. The organic electroluminescent device according to 2, wherein the compound represented by formula (1) contained in the electron-transporting layer is a nitrogen-containing heterocyclic compound.
4. The organic electroluminescent device according to 3, wherein the nitrogen-containing heterocyclic compound is a nitrogen-containing heterocyclic compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.
5. The organic electroluminescent device according to 4, wherein the nitrogen-containing heterocyclic compound is a benzoimidazole derivative represented by formula (3) or (4), 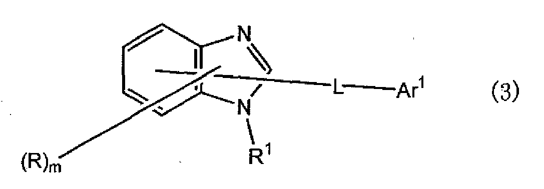 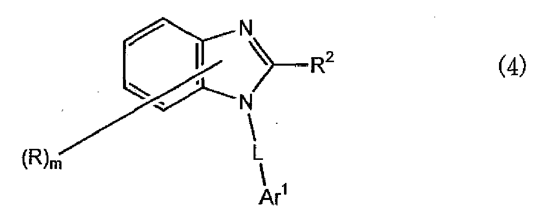 wherein R is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
   m is an integer of 0 to 4;
   R¹ is a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
   R² is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
   L is a C₆₋₆₀ arylene group which may have a substituent, a pyridinylene group which may have a substituent, a quinoliylene group which may have a substituent, or a fluorenylene group which may have a substituent; and
   Ar¹ is a C₆₋₆₀ aryl group which may have a substituent, a pyridinyl group which may have a substituent, or a quinolyl group which may have a substituent.
6. The organic electroluminescent device according to any one of 1 to 5, wherein X, in the formula (2), is a condensed aromatic cyclic group containing at least one skeleton selected from naphthacene, pyrene, anthracene, perylene, chrysene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene.
7. The organic electroluminescent device according to any one of 1 to 6, wherein the compound represented by formula (2) is a naphthacene derivative, a diaminoanthracene derivative, a naphthofluoranthene derivative, a diaminopyrene derivative, a diaminoperylene derivative, an aminoanthracene derivative, an aminopyrene derivative or a dibenzochrysene derivative.
8. The organic electroluminescent device according to any one of 1 to 7, wherein the indenoperylene derivative of the dopant in the emitting layer is a dibenzotetraphenylperiflanthene derivative.
9. The organic electroluminescent device according to any one of 1 to 8, wherein a doping concentration of the dopant in the emitting layer is 0.1 to 10%.
10. The organic electroluminescent device according to 9, wherein a doping concentration of the dopant in the emitting layer is 0.5 to 2%.
11. The organic electroluminescent device according to any one of 1 to 10, of which an emission color is orange to red.

As stated above, according to the invention, an organic EL device with a high efficiency can be obtained by selecting suitable compounds as materials for an electron-transporting layer and an emitting layer. The constitution of the invention enables an organic EL device with a high color purity in which the generation of excitons is suppressed in an electron-transporting layer so that slight emission from the electron-transporting layer is reduced to an even lower level. Further the lifetime of the device can be longer for similar reasons.

The invention provides an organic EL device excellent in color purity with a high efficiency and long lifetime.

### Brief Description of Drawings

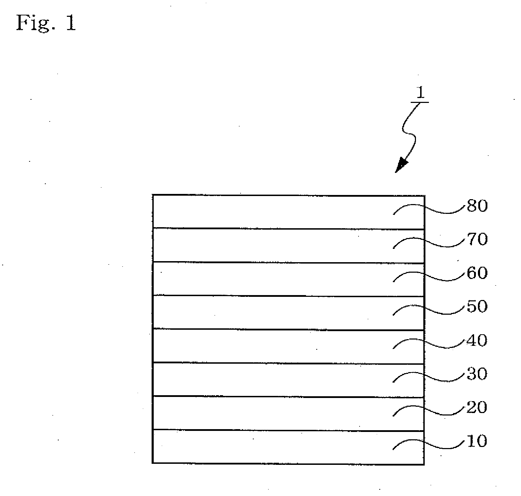

Fig.1 is a view showing an embodiment according to the organic EL device of the invention.

### Preferred Embodiments of the Invention

The organic EL device of the invention comprises an emitting layer and an electron-transporting layer between a cathode and an anode, the electron-transporting layer comprising a compound represented by formula (1), the emitting layer comprising a host material which is a compound with an energy gap of 2.8 eV or less represented by formula (2) and a dopant which is an indenoperylene derivative,

A-B (1)

wherein A is an aromatic hydrocarbon group with three or more carbocycles and B is a substituted or unsubstituted heterocyclic group,

X-(Y)ₙ (2)

wherein X is a condensed aromatic ring group with two or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.

Fig.1 is a sectional view showing one example of an organic EL device according to the invention.
An organic EL device 1 has a structure in which an anode 20, hole-injecting layer 30, hole-transporting layer 40, emitting layer 50, electron-transporting layer 60, electron-injecting layer 70 and cathode 80 are stacked on a substrate 10 in this order. The organic EL device may have various other structures.

In the organic EL device of the invention, the compound represented by formula (1) contained in the electron-transporting layer preferably contains one or more kinds of heterocyclic compounds containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene; and is more preferably a nitrogen-containing heterocyclic compound.
The nitrogen-containing heterocyclic compound contains one or more kinds of nitrogen-containing heterocyclic compounds containing in the molecule thereof at least one skeleton selected from pyridine, pyrimidine, pyrazine, pyridazine, triazine, quinoline, quinoxaline, acridine, imidazopyridine, imidazopyrimidine and phenenthroline. As a nitrogen-containing heterocyclic compound, a benzoimidazole derivative represented by formula (3) or (4) can be exemplified, 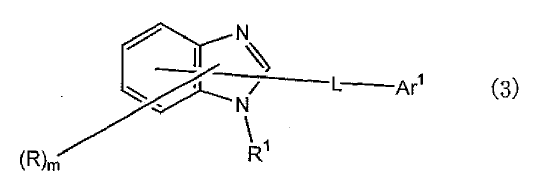 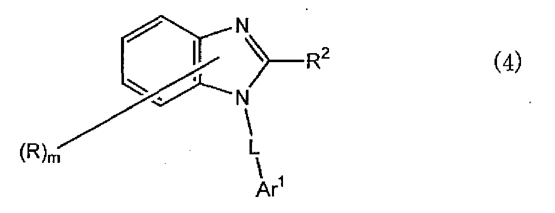 wherein R is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
m is an integer of 0 to 4;
R¹ is a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
R² is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
L is a C₆₋₆₀ arylene group which may have a substituent, a pyridinylene group which may have a substituent, a quinolinylene group which may have a substituent, or a fluorenylene group which may have a substituent; and
Ar¹ is a C₆₋₆₀ aryl group which may have a substituent, a pyridinyl group which may have a substituent, or a quinolinyl group which may have a substituent.

For the benzoimidazole derivative represented by formula (4), m is preferably 0, R² is preferably an aryl group, L is preferably an arylene group with 6 to 30 carbon atoms (more preferably 6 to 20 carbon atoms) and Ar¹ is preferably an aryl group with 6 to 30 carbon atoms.

In the formula (2) representing a host material of an emitting layer, X is preferably a group containing at least one skeleton selected from naphthacene, pyrene, anthracene, perylene, chrysene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene; and more preferably a group containing a naphthacene skeleton or anthracene skeleton. Y is preferably an aryl group or a diarylamino group with 12 to 60 carbon atoms, more preferably an aryl group with 12 to 20 carbon atoms or a diarylamino group with 12 to 40 carbon atoms. n is preferably 2.

The emitting layer of the organic EL device of the invention preferably contains, as a compound represented by formula (2), one or more kinds of compounds selected from a naphthacene derivative, a diaminoanthracene derivative, a naphthofluoranthene derivative, a diaminopyrene derivative, a diaminoperylene derivative, an aminoanthracene derivative, an aminopyrene derivative or a dibenzochrysene derivative. The layer more preferably contains a naphthacene derivative or a diaminoanthracene derivative.

The compound represented by formula (2) has an energy gap of 2.8 eV or less, generally 2.1 to 1.0 eV.

The indenoperylene derivative of the dopant in the emitting layer is preferably a dibenzotetraphenylperiflanthene derivative.

A doping concentration of the dopant in the emitting layer is preferably 0.1 to 10%, more preferably 0.5 to 2%.

An emission color is preferably orange to red.

### [Structure of organic EL device]

The typical examples of the structure of the organic EL device of the invention are shown below. The invention is not limited to these.
(1) Anode/emitting layer/electron-transporting layer/cathode
(2) Anode/hole-transporting layer/emitting layer/electron-transporting layer/cathode
(3) Anode/hole-injecting layer/hole-transporting layer/emitting layer/electron-transporting layer/cathode
(4) Anode/hole-transporting layer/emitting layer/electron-transporting layer/electron-injecting layer/cathode
(5) Anode/hole-injecting layer/hole-transporting layer/emitting layer/electron-transporting layer/electron-injecting layer/cathode
(6) Anode/insulative layer/hole-transporting layer/emitting layer/electron-transporting layer/cathode
(7) Anode/hole-transporting layer/emitting layer/electron-transporting layer/insulative layer/cathode
(8) Anode/insulative layer/hole-transporting layer/emitting layer/electron-transporting layer/insulative layer/cathode
(9) Anode/hole-injecting layer/hole-transporting layer/emitting layer/electron-transporting layer/insulative layer/cathode
(10)Anode/insulative layer/hole-injecting layer/hole-transporting layer/emitting layer/electron-transporting layer/electron-injecting layer/cathode
(11)Anode/insulative layer/hole-injecting layer/hole-transporting layer/emitting layer/electron-transporting layer/electron-injecting layer/insulative layer/cathode
Among these, the structure (2), (3), (4), (5), (8), (9) and (11) are generally preferably used.

### [Transparent substrate]

The organic EL device of the invention is formed on a substrate. When outcoupling light through a substrate, a transparent substrate is used. The transparent substrate is a substrate for supporting the organic EL device, and is preferably a flat and smooth substrate having a transmittance of 50% or more to light rays within visible ranges of 400 to 700 nm.
Specific examples thereof include a glass plate and a polymer plate. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

### [Anode]

The anode of the organic thin film EL device plays a role for injecting holes into its hole-transporting layer or emitting layer. The anode effectively has a work function of 4.5 eV or more. Specific examples of the material of the anode used in the invention include indium tin oxide alloy (ITO), indium zinc oxide alloy (IZO), tin oxide (NESA), gold, silver, platinum, and copper.
Although these materials may be used individually, alloys thereof or materials wherein another element is added to the materials can be selected for use.
The anode can be formed by forming these electrode materials into a thin film by vapor deposition, sputtering or the like.
In the case where luminescence from the emitting layer is taken out through the anode, the transmittance of the anode to the luminescence is preferably more than 10%. The sheet resistance of the anode is preferably several hundreds Ω/□ or less. The film thickness of the anode, which is varied in accordance with the material thereof, is usually selected from 10 nm to 1 µm, preferably from 10 to 200 nm.

### [Emitting layer]

An emitting layer of an organic EL device possesses the following functions:
(a) an injection function; which enables to inject holes from an anode or hole-injecting, transporting layer and to inject electrons from a cathode or electron-injecting, transporting layer, when an electric field is impressed,
(b) a transport function; which transports injected electric charge (electrons and holes) with an electric field's power, and
(c) an emitting function; which provides a recombination site for electrons and holes to emit light.
There may be a difference in ease of injection between holes and electrons, and also a difference in transport capacity that is represented by mobilities of holes and electrons. However, moving one of the electric charges is preferred.

As methods of forming this emitting layer, known methods such as vacuum deposition, spin coating and LB technique can be applied.
An emitting layer is particularly preferably a molecule-deposited film.
The term "molecule-deposited film" here means a thin film that is formed by depositing a material compound in a vapor phase and a film formed by solidifying a material compound in a solution state or liquid state. Usually this molecule-deposited film can be distinguished from a thin film formed by the LB technique (a molecule-accumulated film) by differences in agglutination structure and higher-order structure, and functional differences caused thereby.
As disclosed in JP-A-57-51781, an emitting layer can also be formed by dissolving a binder such as resins and material compound in a solvent to make a solution and forming a thin film therefrom by spin coating and so on.

### [Hole-injecting, transporting layer]

The hole-transporting layer is a layer for helping the injection of holes into the emitting layer so as to transport the holes to a light emitting region. The hole mobility thereof is large and the ionization energy thereof is usually as small as 5.5 eV or less. Such a hole-transporting layer is preferably made of a material which can transport holes to the emitting layer at a lower electric field intensity. The hole mobility thereof is preferably at least 10⁻⁴ cm²/V·second when an electric field of, e.g., 10⁴ to 10⁶ V/cm is applied.
The material for forming the hole-transporting layer is not particularly limited so long as the material has the above-mentioned preferred natures. The material can be arbitrarily selected from materials which have been widely used as a hole-transporting material in photoconductive materials and known materials used in a hole-injecting layer of organic EL devices.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive macromolecular oligomers (in particular thiophene oligomers) disclosed in JP-A-1-211399.

It is preferred to use a material represented by the following formula (4):

Q1-G-Q2 (4)

wherein Q1 and Q2 are sites having at least one tertiary amine, and G is a linking group.

It is more preferred to use an amine derivative represented by the following formula (5): 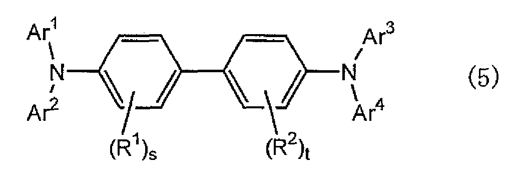 wherein Ar¹ to Ar⁴ are independently a substituted or unsubstituted aromatic ring with 6 to 50 nucleus carbon atoms, or a substituted or unsubstituted hetero aromatic ring with 5 to 50 nucleus atoms; R¹ and R² are a substituent; s and t are independently an integer of 0 to 4; Ar¹ and Ar², and Ar³ and Ar⁴ may be linked to each other to form a ring structure; and R¹ and R² may also be linked to each other to form a ring structure.
The substituents of Ar¹ to Ar⁴, R¹ and R² include substituted or unsubstituted aromatic rings with 6 to 50 nucleus carbon atoms; substituted or unsubstituted hetero aromatic rings with 5 to 50 nucleus atoms; alkyl groups with 1 to 50 carbon atoms; alkoxy groups with 1 to 50 carbon atoms; alkylaryl groups with 1 to 50 carbon atoms; aralkyl groups with 1 to 50 carbon atoms; a styryl group; amino groups substituted with aromatic rings with 6 to 50 nucleus carbon atoms or hetero aromatic rings with 5 to 50 nucleus atoms; or aromatic rings with 6 to 50 nucleus carbon atoms or hetero aromatic rings with 5 to 50 nucleus atoms substituted with amino groups substituted with aromatic rings with 6 to 50 nucleus carbon atoms or hetero aromatic rings with 5 to 50 nucleus atoms.

Further, a hole-injecting layer can be provided in addition to the hole-transporting layer so as to help the injection of holes. The material of the hole-transporting layer can be used as the material of the hole-injecting layer. The following are preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis(N-(1-naphthyl)-N-phenylamino)buphenyl (hereinafter abbreviated to NPD), which has in the molecule thereof two condensed aromatic rings, disclosed in USP No. 5,061,569, and 4,4',4"-tris(N-(3-methylphenyl)-N-phenylamino)triphenylamine (hereinafter abbreviated to MTDATA), wherein three triphenylamine units are linked to each other in a star-burst form, disclosed in JP-A-4-308688.
The material represented by the formula (4) or (5) are particularly preferred.
In addition to aromatic dimethylidene type compounds, inorganic compounds such as p-type Si and p-type SiC can also be used as the material of the hole-transporting layer.

The hole-injecting, transporting layer can be formed by making the above-mentioned compound(s) into a thin film by a known method, such as vacuum deposition, spin coating, casting or LB technique. The film thickness of the hole-injecting, transporting layer is not particularly limited, and is usually from 5 nm to 5 µm. This hole-injecting, transporting layer may be a single layer made of one or more out of the above-mentioned materials. This hole-injecting, transporting layer may be stacked layers made of different compounds.

The organic semiconductive layer is also a type of the hole-transporting layer. The organic semiconductive layer is a layer for helping the injection of holes or electrons into the emitting layer, and is preferably a layer having an electroconductivity of 10⁻¹⁰ S/cm or more. The material of such an organic semiconductive layer may be an electroconductive oligomer, such as thiophene-containing oligomer or arylamine-containing oligomer disclosed in JP-A-8-193191, and an electroconductive dendrimer such as arylamine-containing dendrimer.

### [Electron-injecting layer]

The electron-injecting layer is a layer for helping the injection of electrons into the emitting layer, and has a large electron mobility. The adhesion improving layer is a layer made of a material particularly good in adhesion to the cathode among such electron-injecting layers.

A preferred embodiment of the invention is a device containing a reducing dopant in an interfacial region between its electron transferring region or cathode and its organic layer. The reducing dopant is defined as a substance which can reduce an electron transferring compound. Accordingly, various substances which have given reducing properties can be used. For example, at least one substance can be preferably used which is selected from the group consisting of alkali metals, alkaline earth metals, rare earth metals, alkali metal oxides, alkali metal halides, alkaline earth metal oxides, alkaline earth metal halides, rare earth metal oxides, rare earth metal halides, alkali metal organic complexes, alkaline earth metal organic complexes, and rare earth metal organic complexes.

More specific examples of the preferred reducing dopants include at least one alkali metal selected from the group consisting of Na (work function: 2.36 eV), K (work function: 2.28 eV), Rb (work function: 2.16 eV) and Cs (work function: 1.95 eV), and at least one alkaline earth metal selected from the group consisting of Ca (work function: 2.9 eV), Sr (work function: 2.0 to 2.5 eV), and Ba (work function: 2.52 eV). Metals having a work function of 2.9 eV or less are in particular preferred. Among these, a more preferable reducing dopant is at least one alkali metal selected from the group consisting of K, Rb and Cs. Even more preferable is Rb or Cs. Most preferable is Cs. These alkali metals are particularly high in reducing ability. Thus, the addition of a relatively small amount thereof to an electron injecting zone makes it possible to improve the luminance of the organic EL device and make the life time thereof long. As the reducing dopant having a work function of 2.9 eV or less, any combination of two or more out of these alkali metals is also preferred. Particularly preferred is any combination containing Cs, for example, a combination of Cs and Na, Cs and K, Cs and Rb, or Cs, Na and K. The combination containing Cs makes it possible to exhibit the reducing ability efficiently. The luminance of the organic EL device can be improved and the life time thereof can be made long by the addition thereof to its electron injecting zone.

In the invention, an electron-injecting layer which is formed of an insulator or a semiconductor may further be provided between a cathode and an organic layer. By providing the layers, current leakage can be effectively prevented to improve the injection of electrons. As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be further improved, it being preferably. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Examples of the semiconductor for forming an electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof. The inorganic compound for an electron-injecting layer is preferably a microcrystalline or amorphous insulating thin film. When an electron-injecting layer is formed of the insulating thin film, a more uniform thin film can be formed to reduce pixel defects such as dark spots. Examples of such an inorganic compound include the above-mentioned alkali metal calcogenides, alkaline earth metal calcogenides, halides of alkali metals, and halides of alkaline earth metals.

### Cathode

For the cathode, the following may be used: an electrode substance made of a metal, an alloy or an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.

This cathode can be formed by making the electrode substance(s) into a thin film by vapor deposition, sputtering or some other method.
In the case where luminescence from the emitting layer is taken out through the cathode, it is preferred to make the transmittance of the cathode to the luminescence larger than 10%.
The sheet resistance of the cathode is preferably several hundreds Ω/□ or less, and the film thickness thereof is usually from 10 nm to 1 µm, preferably from 50 to 200 nm.

### [Insulative layer]

In the organic EL device, pixel defects based on leakage or a short circuit are easily generated since an electric field is applied to the super thin film. In order to prevent this, it is preferred to insert an insulator thin layer between the pair of electrodes.

Examples of the material used in the insulative layer include aluminum oxide, lithium fluoride, lithium oxide, cesium fluoride, cesium oxide, magnesium oxide, magnesium fluoride, calcium oxide, calcium fluoride, cesium fluoride, cesium carbonate, aluminum nitride, titanium oxide, silicon oxide, germanium oxide, silicon nitride, boron nitride, molybdenum oxide, ruthenium oxide, and vanadium oxide.
In the invention, a mixture or laminate thereof may be used.

### [Examples of fabricating an organic EL device]

The organic EL element can be produced by forming an anode, an emitting layer and an electro-transporting layer, optionally forming a hole-injecting layer and an electron-injecting layer, and further forming a cathode by use of the materials and methods exemplified above. The organic EL element can also be produced in the order reverse to the above, i.e., the order from a cathode to an anode.

An example of the production of the organic EL element will be described below which has a structure wherein the following are successively formed over a transparent substrate: anode/hole-transporting layer/emitting layer/electron-transporting layer/cathode.
First, a thin film made of an anode material is formed into a thickness of 1 µm or less, preferably 10 to 200 nm on an appropriate transparent substrate by vapor deposition, sputtering or some other method, thereby forming an anode.
Next, a hole-transporting layer is formed on this anode. As described above, the hole-transporting layer can be formed by vacuum deposition, spin coating, casting, LB technique, or some other method. Vacuum deposition is preferred since a homogenous film is easily obtained and pinholes are not easily generated. In the case where the hole-transporting layer is formed by vacuum deposition, conditions for the deposition are varied in accordance with the used compound (the material for the hole-transporting layer), the crystal structure or recombining structure of the hole-transporting layer, and others. In general, the conditions are appropriately selected from the following: deposition source temperatures of 50 to 450°C, vacuum degrees of 10⁻⁷ to 10⁻³ torr, vapor deposition rates of 0.01 to 50 nm/second, substrate temperatures of -50 to 300°C, and film thicknesses of 5 nm to 5 µm.

Next, an emitting layer is disposed on the hole-transporting layer. The emitting layer can be formed by using a desired organic luminescent material and making the material into a thin film by vacuum deposition, sputtering, spin coating, casting or some other method. Vacuum deposition is preferred since a homogenous film is easily obtained and pinholes are not easily generated. In the case where the emitting layer is formed by vacuum deposition, conditions for the deposition, which are varied dependently on the used compound, can be generally selected from conditions similar to those for the hole-injecting layer.

Next, an electron-transporting layer is formed on this emitting layer. Like the hole-transporting layer and the emitting layer, the layer is preferably formed by vacuum deposition in order to obtain a homogenous film. Conditions for the deposition can be selected from conditions similar to those for the hole-transporting layer and the emitting layer.
Lastly, a cathode is laminated thereon to obtain an organic EL element.

The cathode is made of a metal, and vapor deposition or sputtering may be used. However, vacuum deposition is preferred in order to protect underlying organic layers from being damaged when the cathode film is formed.
For the organic EL element production that has been described above, it is preferred that the formation from the anode to the cathode is continuously carried out, using only one vacuuming operation.

The method for forming each of the layers in the organic EL device of the invention is not particularly limited. A known forming method, such as vacuum deposition, molecular beam deposition, spin coating, dipping, casting, bar coating or roll coating can be used.

The film thickness of each of the organic layers in the organic EL device of the invention is not particularly limited. In general, defects such as pinholes are easily generated when the film thickness is too small. Conversely, a high applied voltage becomes necessary to make the efficiency bad when the film thickness is too large. Usually, therefore, the film thickness is preferably in the range of several nanometers to one micrometer.

### [Examples]

The energy gap of a host material used in Examples was measured by the following method.
A compound was solved in toluene to form a solution of 10⁻⁵ mol/l. The solution was measured for absorption spectra with a spectrophotometer (U-3410, supplied by Hitachi Corporation). The tangent line was drawn against the rise on the long wavelength side in the ultraviolet absorption spectra, and then the wavelength at the intersection of the tangent line with the horizontal axis (absorption edge) was obtained. An energy gap was calculated by converting the wavelength to an energy value.

### Example 1

A 120 nm thick transparent electrode made of indium tin oxide was formed on a glass substrate measuring 25 mm x 75 mm x 0.7 mm. The glass substrate was subjected to ultrasonic cleaning in isopropyl alcohol for 5 minutes, and then subjected to UV ozone cleaning for 30 minutes. The glass substrate was placed in a vacuum deposition device.
First, as a hole-injection layer, N',N''-bis[4-(diphenylamino)phenyl]-N',N''-diphenylbiphenyl-4,4'-diamine was deposited to a thickness of 60 nm on the substrate. Then, as a hole-transporting layer, tetrakis-N-(4-biphenyl)benzidine was deposited to a thickness of 10 nm thereon. Next, as an emitting layer, the compound (A-1) of a naphthacene derivative below and the compound (B) of an indenoperylene derivative below were co-deposited to a thickness of 40 nm at a weight ratio of 40:0.4.

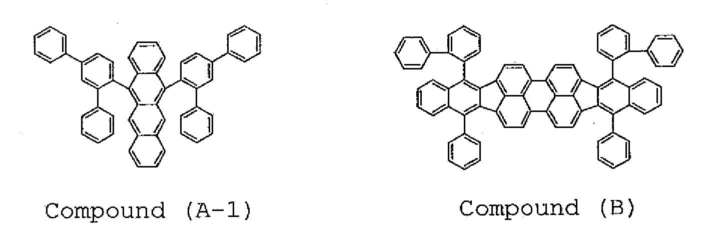

Next, as an electron-transporting layer, a compound (C-1) below was deposited to a thickness of 30 nm.

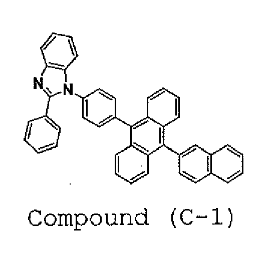

Next, a lithium fluoride was deposited to a thickness of 0.3 nm, and then aluminum was deposited to 150 nm. This aluminum/lithium fluoride functioned as a cathode. An organic EL device was thus obtained.
When an electrical conduction test was performed for the device obtained, red emission with a driving voltage of 4.1 V and a luminance of 1,135 cd/m² was obtained at a current density of 10 mA/cm². Chromaticity coordinates were (0.67, 0.33), and a luminous efficiency was 11.35 cd/A. When a direct current continuous conduction test was performed at an initial luminance of 5,000 cd/m², a driving period of time until the luminance reached 80% of the initial luminance was 2,100 hours.

### Example 2

An organic EL device was fabricated in the same way as in Example 1 except that the compound (A-3) below of a diaminoanthracene derivative was used instead of the compound (A-1) when the emitting layer was formed. 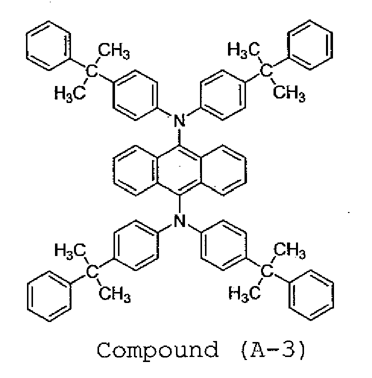 When an electrical conduction test was performed for the device obtained, red emission with a driving voltage of 4.1 V and a luminance of 978 cd/m² was obtained at a current density of 10 mA/cm². Chromaticity coordinates were (0.67, 0.33), and a luminous efficiency was 9.78 cd/A. When a direct current continuous conduction test was performed at an initial luminance of 5,000 cd/m², a half life was 2,000 hours.

### Comparative example 1

An organic EL device was fabricated in the same way as in Example 1 except that, when forming the electron-transporting layer, instead of the compound (C-1), the compound (A-1) was deposited to a thickness of 25 nm, and a bathophenanthroline (BPhen) was sequentially deposited to a thickness of 5 nm, thereby forming an electron-transporting layer. 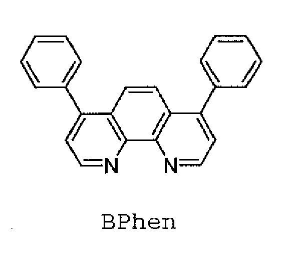 When an electrical conduction test was performed for the device obtained, red emission with a driving voltage of 3.9 V and a luminance of 730 cd/m² was obtained at a current density of 10 mA/cm². Chromaticity coordinates were (0.67, 0.33), and a luminous efficiency was 7.30 cd/A. When a direct current continuous conduction test was performed at an initial luminance of 5,000 cd/m², a driving period of time until the luminance reached 80% of the initial luminance was 2,700 hours.

### Comparative example 2

An organic EL device was fabricated in the same way as in Example 1 except that tris(8-hydroxy quinolinato)aluminum (hereinafter Alq₃) was used instead of the compound (C-1) when the electron-transporting layer was formed. 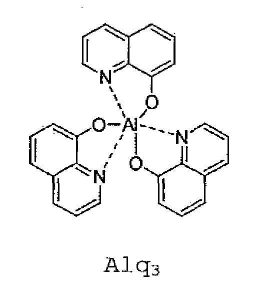 When an electrical conduction test was performed for the device obtained, red emission with a driving voltage of 4.9 V and a luminance of 703 cd/m² was obtained at a current density of 10 mA/cm². Chromaticity coordinates were (0.65, 0.35), and a luminous efficiency was 7.03 cd/A. When a direct current continuous conduction test was performed at an initial luminance of 5,000 cd/m², a driving period of time until the luminance reached 80% of the initial luminance was 360 hours.

### Comparative example 3

An organic EL device was fabricated in the same way as in Example 1 except that the compound (A-4) below of an anthracene derivative with an energy gap of 3.0 eV was used instead of the compound (A-1) when the emitting layer was formed, and the Alq₃ was used instead of the compound (C-1) when the electron-transporting layer was formed. 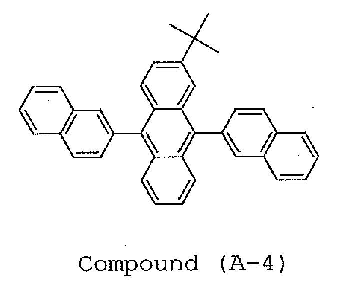 When an electrical conduction test was performed for the device obtained, pink emission with a driving voltage of 6.1 V and a luminance of 149 cd/m² was obtained at a current density of 10 mA/cm². Chromaticity coordinates were (0.58, 0.30), and a luminous efficiency was 1.49 cd/A. When a direct current continuous conduction test was performed at an initial luminance of 5,000 cd/m², a driving period of time until the luminance reached 80% of the initial luminance was 30 hours.

### Comparative example 4

An organic EL device was fabricated in the same way as in Example 2 except that the Alq₃ was used instead of the compound (C-1) when the electron-transporting layer was formed.
When an electrical conduction test was performed for the device obtained, red emission with a driving voltage of 5.3 V and a luminance of 622 cd/m² was obtained at a current density of 10 mA/cm². Chromaticity coordinates were (0.65, 0.35), and a luminous efficiency was 6.22 cd/A. When a direct current continuous conduction test was performed at an initial luminance of 5,000 cd/m², a driving period of time until the luminance reached 80% of the initial luminance was 310 hours.

**Table 1**

| | Host material | Eg of host | Dopant | Electron-transporting material | Driving voltage | Luminous efficiency | Chromaticity | 80% life time |
|---|---|---|---|---|---|---|---|---|
| | | (eV) | | | (V) | (cd/A) | (x,y) | (h) |
| Example 1 | A-1 | 2.4 | B | C-1 | 4.1 | 11.35 | (0.67,0.33) | 2100 |
| Example 2 | A-3 | 2.4 | B | C-1 | 4.1 | 9.78 | (0.67,0.33) | 2000 |
| Comparative example 1 | A-1 | 2.4 | B | A-1/BPhen | 3.9 | 7.30 | (0.67,0.33) | 2700 |
| Comparative example 2 | A-1 | 2.4 | B | Alq₃ | 4.9 | 7.03 | (0.65,0.35) | 360 |
| Comparative example 3 | A-4 | 3.0 | B | Alq₃ | 6.1 | 1.49 | (0.58,0.30) | 30 |
| Comparative example 4 | A-3 | 2.4 | B | Alq₃ | 5.3 | 6.22 | (0.65,0.35) | 310 |

### Industrial Applicability

The organic EL device of the invention can be used in fields such as various displays, display apparatuses, backlight, illumination light sources, signs, advertising boads and interior, and are particularly suitable for display devices of color displays.

## Claims

1. An organic electroluminescent device comprising,
an emitting layer and an electron-transporting layer between a cathode and an anode,
the electron-transporting layer comprising a compound represented by formula (1),
the emitting layer comprising a host material which is a compound with an energy gap of 2.8 eV or less represented by formula (2) and a dopant which is an indenoperylene derivative,
A-B (1)
wherein A is an aromatic hydrocarbon group with three or more carbocycles and B is a substituted or unsubstituted heterocyclic group,
X-(Y)ₙ (2)
wherein X is a condensed aromatic ring group with three or more carbocycles, Y is a group selected from substituted or unsubstituted aryl, substituted or unsubstituted diarylamino, substituted or unsubstituted arylalkyl and substituted or unsubstituted alkyl groups, and n is an integer of 1 to 6, provided that Ys may be the same or different when n is 2 or more.

2. The organic electroluminescent device according to claim 1, wherein the compound represented by formula (1) contained in the electron-transporting layer is a compound containing in the molecule thereof at least one skeleton selected from anthracene, phenanthrene, naphthacene, pyrene, chrysene, benzoanthracene, pentacene, dibenzoanthracene, benzopyrene, fluorene, benzofluorene, fluoranthene, benzofluoranthene, naphthofluoranthene, dibenzofluorene, dibenzopyrene and dibenzofluoranthene.

3. The organic electroluminescent device according to claim 2, wherein the compound represented by formula (1) contained in the electron-transporting layer is a nitrogen-containing heterocyclic compound.

4. The organic electroluminescent device according to claim 3, wherein the nitrogen-containing heterocyclic compound is a nitrogen-containing heterocyclic compound containing in the molecule thereof at least one skeleton selected from pyridine, pyrimidine, pyrazine, pyridazine, triazine, quinoline, quinoxaline, acridine, imidazopyridine, imidazopyrimidine and phenenthroline.

5. The organic electroluminescent device according to claim 4, wherein the nitrogen-containing heterocyclic compound is a benzoimidazole derivative represented by formula (3) or (4), 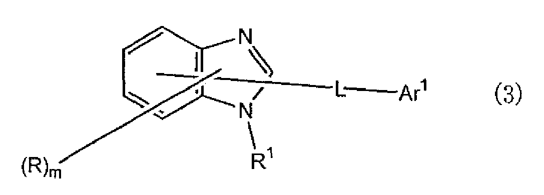 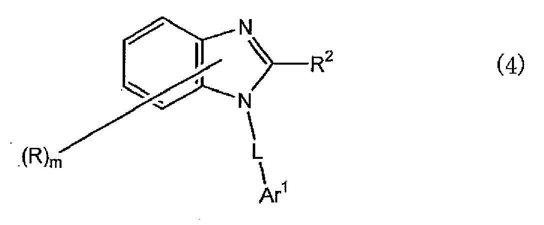 wherein R is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
m is an integer of 0 to 4;
R¹ is a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
R² is a hydrogen atom, a C₆₋₆₀ aryl group which may have a substituent, a pyridyl group which may have a substituent, a quinolyl group which may have a substituent, a C₁₋₂₀ alkyl group which may have a substituent, or a C₁₋₂₀ alkoxy group which may have a substituent;
L is a C₆₋₆₀ arylene group which may have a substituent, a pyridinylene group which may have a substituent, a quinolinylene group which may have a substituent, or a fluorenylene group which may have a substituent; and
Ar¹ is a C₆₋₆₀ aryl group which may have a substituent, a pyridinyl group which may have a substituent, or a quinolinyl group which may have a substituent.

6. The organic electroluminescent device according to any one of claims 1 to 5, wherein X, in the formula (2), is a condensed aromatic cyclic group containing at least one skeleton selected from naphthacene, pyrene, anthracene, perylene, chrysene, benzoanthracene, pentacene, dibenzoanthracene, benzopyrene, benzofluorene, fluoranthene, benzofluoranthene, naphthylfluoranthene, dibenzofluorene, dibenzopyrene, dibenzofluoranthene and acenaphtylfluoranthene.

7. The organic electroluminescent device according to any one of claims 1 to 6, wherein the compound represented by formula (2) is a naphthacene derivative, a diaminoanthracene derivative, a naphthofluoranthene derivative, a diaminopyrene derivative, a diaminoperylene derivative, an aminoanthracene derivative, an aminopyrene derivative or a dibenzochrysene derivative.

8. The organic electroluminescent device according to any one of claims 1 to 7, wherein the indenoperylene derivative of the dopant in the emitting layer is a dibenzotetraphenylperiflanthene derivative.

9. The organic electroluminescent device according to any one of claims 1 to 8, wherein a doping concentration of the dopant in the emitting layer is 0.1 to 10%.

10. The organic electroluminescent device according to claim 9, wherein a doping concentration of the dopant in the emitting layer is 0.5 to 2%.

11. The organic electroluminescent device according to any one of claims 1 to 10, of which an emission color is orange to red.
